# EUROPÄISCHE PATENTANMELDUNG

(11) **EP 1 492 156 A1**
(43) Veröffentlichungstag der Anmeldung: **29.12.2004**
(21) Anmeldenummer: 03101888.0
(22) Anmeldetag: 25.06.2003
(51) Int. Cl.: H01L 21/00

(54) **Verfahren und Pick and Place System fuer die Montage von Flipchips**

(71) Anmelder: Esec Trading S.A., 6330 Cham (CH)
(72) Erfinder: KALTENBACH, Stefan, 4500, Solothurn (CH); FISCHER, Ernst, 3267, Seedorf (CH); ZIMMERMANN, Heinz, 4583, Aetigkofen SO (CH)
(74) Vertreter: Falk, Urs, Dr.

(57) **Zusammenfassung**

Ein Verfahren für die Montage eines Flipchips (9) auf einem Substrat (16), wobei der Flipchip (9) an einer Oberfläche angeordnete Bumps enthält, ist dadurch gekennzeichnet, dass
- der Flipchip (9) von einem Wafer (10) entnommen und in einer an einem ersten Ort bereitgestellten, ein Flussmittel enthaltenden Kavität (11) einer Benetzungsstation (3) abgesetzt wird,
- die Kavität (11) an einen zweiten Ort bewegt wird, und
- der Flipchip (9) von einem Bestückungskopf (4) am zweiten Ort aus der Kavität (11) entnommen und auf dem Substrat (16) platziert wird.

Ein für die Durchführung des Verfahrens geeignetes Pick and Place System weist einen Antrieb (15) auf, der die Kavität (11) zwischen dem ersten und dem zweiten Ort hin und her bewegt.

## Beschreibung

Die Erfindung betrifft ein Verfahren für die Montage von Flipchips der im Oberbegriff des Anspruchs 1 genannten Art und ein für die Durchführung des Verfahrens geeignetes Pick and Place System.

Ein Flipchip ist ein Halbleiterchip, dessen elektrische Kontaktstellen mit einem sogenannten Bump versehen sind. Wenn der Flipchip auf einem Substrat montiert wird, dann zeigt die mit den Bumps versehene Oberfläche des Flipchips zum Substrat, d.h. die elektrische Verbindung zwischen dem Flipchip und dem Substrat erfolgt über die Bumps.

Die Montage der Flipchips erfolgt entweder mit einem sogenannten Pick and Place System oder mit einem Die Bonder. Die Pick and Place Systeme sind langsamer als die Die Bonder, dafür können Sie die Flipchips mit grösserer Genauigkeit positionieren. Zudem sind Pick and Place Systeme flexibler, d.h. sie ermöglichen die Bestückung von Substraten mit verschiedenen Halbleiterchips. Die Montage eines Flipchips mittels eines Pick and Place Systems erfolgt gemäss den folgenden Verfahrensschritten:
- Der Halbleiterchip wird von einem Wafertisch entnommen und an eine Flip-Vorrichtung übergeben,
- die Flip-Vorrichtung dreht den Halbleiterchip um 180° und hält ihn für einen Bestückungskopf bereit,
- der Bestückungskopf entnimmt den Halbleiterchip von der Flip-Vorrichtung, fährt zu einer Benetzungsstation, wo er den Halbleiterchip in eine mit einem Flussmittel gefüllte Kavität eintaucht, um die Bumps des Halbleiterchips mit dem Flussmittel zu benetzen, und fährt nach einer vorbestimmten Verweildauer zum Substrat, wo er den Halbleiterchip auf dem Substrat platziert.
Ein solches Pick and Place System wird beispielsweise von der Anmelderin unter dem Produktnamen "Micron" vertrieben.

Um den Durchsatz eines solchen Pick and Place Systems zu erhöhen, wird der Bestückungskopf mit mehreren Sauggreifern, beispielsweise zwei oder vier Sauggreifern, ausgerüstet, damit gleichzeitig entsprechend der Anzahl der Sauggreifer mehrere Flipchips in einem Arbeitsgang montiert werden können.

Der Erfindung liegt die Aufgabe zugrunde, ein Pick and Place System zu entwickeln, das einen höheren Durchsatz ermöglicht.

Die genannte Aufgabe wird erfindungsgemäss gelöst durch die Merkmale des Anspruchs 1.

Für die Lösung der Aufgabe wird erfindungsgemäss vorgeschlagen, die Benetzung der Bumps des Halbleiterchips mit Flussmittel nicht mehr mit dem Bestückungskopf durchzuführen, sondern bevor der Halbleiterchip vom Bestückungskopf aufgenommen wird. Die Montage der Halbleiterchips erfolgt erfindungsgemäss gemäss den folgenden Verfahrensschritten:
- der Halbleiterchip wird mittels eines Übergabekopfs vom Wafer entnommen und an die Flip-Vorrichtung übergeben,
- die Flip-Vorrichtung dreht den Halbleiterchip um 180° und setzt ihn in einer an einem ersten Ort A bereitgestellten Kavität der Benetzungsstation ab, wobei seine Bumps in die Flüssigkeit eintauchen,
- die Benetzungsstation bewegt die Kavität an einen zweiten Ort B, und
- der Halbleiterchip wird vom Bestückungskopf aus der Kavität entnommen und auf dem Substrat platziert.
Damit dieser Ablauf möglich ist, ist die Benetzungsstation mit einem Antrieb versehen, der die Kavität zwischen dem ersten Ort A, wo sie den Halbleiterchip von der Flip-Vorrichtung erhält, und dem zweiten Ort B, wo der Halbleiterchip vom Bestückungskopf aus der Kavität entnommen wird, hin und her bewegt.

Die Hin und her Bewegung der Kavität zwischen den beiden Orten A und B ist aus konstruktiven Gründen nötig, weil der die Flüssigkeit enthaltende Behälter der Benetzungsstation eine gewisse Grösse aufweist. Dank der Hin und her Bewegung der Kavität kann der Transportweg des Bestückungskopfs unabhängig von der Position und Grösse des Flüssigkeitsbehälters gewählt werden.

Während bei Pick and Place Systemen gemäss dem Stand der Technik der Durchsatz von der Verweildauer des Flipchips in der Benetzungsstation abhängt, ist der Durchsatz bei einem erfindungsgemässen Pick and Place System unabhängig von der Verweildauer des Flipchips in der Benetzungsstation.

Es kommt auch vor, dass die Flipchips auf dem Wafer so präsentiert werden, dass die Oberfläche mit den Bumps nicht dem Übergabekopf zugewandt sondern diesem abgewandt ist, so dass der Flipchip ohne zu flippen in der Kavität der Benetzungsstation abgesetzt werden kann. In diesem Fall platziert der Übergabekopf den Flipchip direkt in der Kavität der Benetzungsstation.

Nachfolgend werden Ausführungsbeispiele der Erfindung anhand der Zeichnung näher erläutert.

Es zeigen:
- Fig. 1: ein erstes Ausführungsbeispiel eines erfindungsgemässen Pick and Place Systems, und
- Fig. 2: eine Benetzungsstation eines erfindungsgemässen Pick and Place Systems.

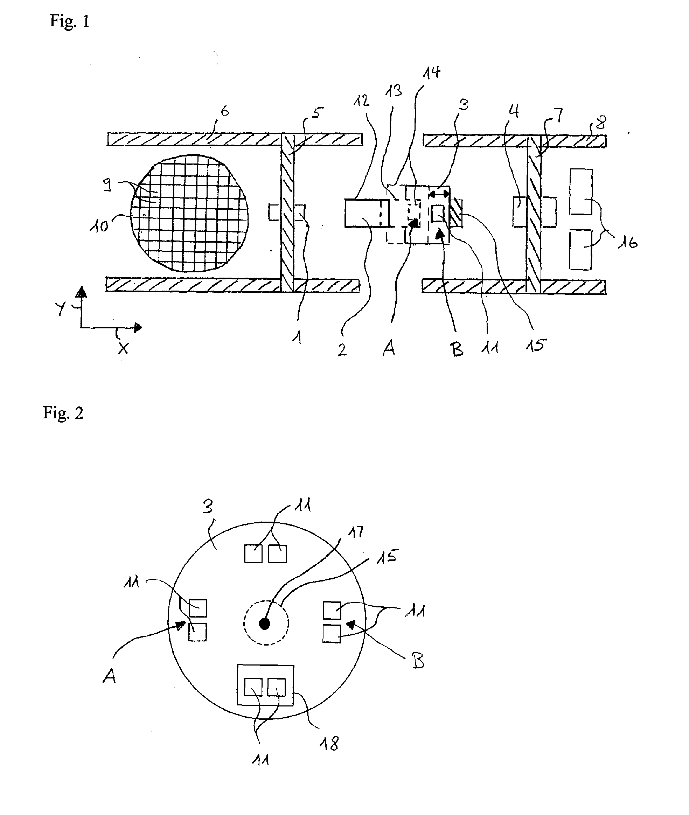

Die Fig. 1 zeigt schematisch und in Aufsicht ein erstes Ausführungsbeispiel eines erfindungsgemässen Pick and Place Systems. Das Pick and Place System umfasst einen Übergabekopf 1, eine Flip-Vorrichtung 2, eine Benetzungsstation 3 und einen Bestückungskopf 4. Der Übergabekopf 1 und der Bestückungskopf 4 sind unabhängig voneinander in zwei orthogonal zueinander verlaufenden, mit x und y bezeichneten Richtungen bewegbar. Der Übergabekopf 1 ist beispielsweise entlang eines Balkens 5 in der y-Richtung verschiebbar, während der Balken 5 auf zwei Schienen 6 in der x-Richtung verschiebbar ist. In gleicher Weise ist der Bestückungskopf 4 entlang eines Balkens 7 in der y-Richtung verschiebbar, während der Balken 7 auf zwei Schienen 8 in der x-Richtung verschiebbar ist. Die zu montierenden Flipchips 9 werden von einem in die einzelnen Flipchips 9 zersägten, auf einer Trägerfolie präsentierten Wafer 10 entnommen. Die Bumps der Flipchips 9 befmden sich auf der dem Übergabekopf 1 zugewandten Oberfläche der Flipchips 9. Der Übergabekopf 1 entnimmt einen Flipchip 9 nach dem andern vom Wafer 10 und übergibt ihn an die Flip-Vorrichtung 2. Die Flip-Vorrichtung 2 dreht den Flipchip 9 um 180° und setzt ihn in einer an einem ersten Ort A bereitgestellten, mit einem Flussmittel gefüllten Kavität 11 der Benetzungsstation 3 ab, so dass seine Bumps in das Flussmittel eintauchen. Eine erste Lage der Flip-Vorrichtung 2, in der sie den Flipchip 9 vom Übergabekopf 1 annimmt, ist mit einer ausgezogenen Linie 12 dargestellt, während eine zweite Lage der Flip-Vorrichtung 2, in der sie den Flipchip 9 in der Kavität 11 absetzt, mit gestrichelter Linie 13 dargestellt ist. In der in der Fig. 1 dargestellten Situation befmdet sich die Kavität 11 der Benetzungsstation 3 an einem zweiten Ort B. Die Kavität 11 ist in eine Platte eingearbeitet. Des Verständnisses wegen ist, mit einer gestrichelten Linie 14, auch die Lage der Platte mit der Kavität 11 dargestellt, wenn sich die Kavität 11 am Ort A befindet. Die Verschiebung der Platte zwischen den beiden Orten A und B ist durch einen Doppelpfeil symbolisiert. Ein Antrieb 15 bewegt die Kavität 11 entlang der x-Achse vom ersten Ort A zum zweiten Ort B, wo der Flipchip 9 nach Ablauf der Verweildauer oder später vom Bestückungskopf 4 aufgenommen und auf dem Substrat 16 montiert wird (In der Fig. 1 sind zwei Substrate 16 dargestellt, da oft mehrere Substrate gleichzeitig bestückt werden). Sobald der Bestückungskopf 4 den Flipchip 9 aus der Kavität 11 entnommen hat, bewegt der Antrieb 15 die Kavität 11 vom zweiten Ort B wieder zum ersten Ort A zurück.

Der Bestückungskopf 4 weist vorzugsweise zwei oder mehr Sauggreifer auf, die je einen Flipchip 9 aufnehmen. Dementsprechend weist auch die Benetzungsstation 3 eine der Anzahl der Sauggreifer angepasste Anzahl an Kavitäten 11 auf, so dass pro Arbeitszyklus zwei oder entsprechend mehr Flipchips 9 montiert werden können. Vorzugsweise ist auch die Flip-Vorrichtung 2 eingerichtet, eine der Anzahl der Sauggreifer entsprechende Zahl von Flipchips 9 aufnehmen und gleichzeitig drehen zu können. Die Arbeitsweise eines Pick and Place Systems mit einer Anzahl n an Sauggreifern erfolgt dann so:
- Der Übergabekopf 1 entnimmt nacheinander n Flipchips 9 vom Wafer 10 und übergibt sie an die Flip-Vorrichtung 2, unabhängig davon, ob der Übergabekopf 1 nur einen einzigen Sauggreifer oder wie der Bestückungskopf 4 ebenfalls n Sauggreifer aufweist.
- Die Flip-Vorrichtung 2 dreht die erhaltenen Flipchips 9 um 180° und setzt sie in den am Ort A bereitgestellten n Kavitäten 11 der Benetzungsstation 3 ab.
- Der Antrieb 15 transportiert die Kavitäten 11 zum Ort B.
- Der Bestückungskopf 4 holt die Flipchips 9 am Ort B ab und transportiert sie zum Substrat 16, wobei die Lage und Orientierung der Flipchips 9 während des Transports mittels eines Sensors bestimmt werden, so dass die Flipchips 9 lagegenau auf dem Substrat 16 platziert werden.

Die Bewegungen des Übergabekopfs 1, der Flip-Vorrichtung 2 und des Antriebs 15 der Benetzungsstation 3 erfolgen parallel und aufeinander abgestimmt mit dem Ziel, dass der Bestückungskopf 4 die Flipchips 9 pausenlos montieren kann.

Es kommt auch vor, dass die Flipchips 9 auf dem Wafer 10 so präsentiert werden, dass die Oberfläche mit den Bumps nicht dem Übergabekopf 1 zugewandt ist, so dass die Flipchips 9 ohne zu flippen in den Kavitäten 11 der Benetzungsstation 3 abgesetzt werden können. In diesem Fall platziert der Übergabekopf 1 die Flipchips 9 direkt in den Kavitäten 11 der Benetzungsstation 3.

Die Fig. 2 zeigt schematisch und in Aufsicht ein weiteres Beispiel einer Benetzungsstation 3 eines erfindungsgemässen Pick and Place Systems, bei dem der Antrieb 15 die Kavität 11 um eine in vertikaler Richtung verlaufende Drehachse 17 dreht, um die Kavität 11 vom Ort A zum Ort B zu transportieren. Beim Rücktransport vom Ort B zum Ort A wird die Kavität 11 unter einem nach unten offenen Behälter 18, der das Flussmittel enthält, hindurchbewegt, wobei die Kavität 11 mit Flussmittel gefüllt wird. Dieses Ausführungsbeispiel ermöglicht es, eine Vielzahl von Kavitäten 11 vorzusehen, so dass auch bei einer langen erforderlichen Verweildauer der Durchsatz des Pick and Place Systems nicht durch die Verweildauer begrenzt wird.

Beim ersten Ausführungsbeispiel wird die Kavität 11 entlang der x-Achse zwischen den beiden Orten A und B hin und her bewegt. Beim zweiten Beispiel wird die Kavität 11 um die Drehachse 17 gedreht. Die Transportzeit vom Ort A zum Ort B ist der Arbeitsweise des Pick and Place Systems und auch der erforderlichen Verweildauer des Flipchips 9 in der Kavität 11 derart angepasst, dass der Transport so langsam wie möglich erfolgt, damit sich die Lage des Flipchips 9 relativ zur Kavität 11 durch die beim Transport erfolgenden Beschleunigungen möglichst wenig verändert.

## Patentansprüche

1. Verfahren für die Montage eines Flipchips (9) auf einem Substrat (16), wobei der Flipchip (9) an einer Oberfläche angeordnete Bumps enthält, **dadurch gekennzeichnet, dass**
- der Flipchip (9) von einem Wafer (10) entnommen und in einer an einem ersten Ort bereitgestellten, ein Flussmittel enthaltenden Kavität (11) einer Benetzungsstation (3) abgesetzt wird,
- die Kavität (11) an einen zweiten Ort bewegt wird, und
- der Flipchip (9) von einem Bestückungskopf (4) am zweiten Ort aus der Kavität (11) entnommen und auf dem Substrat (16) platziert wird.

2. Verfahren nach Anspruch 1, **dadurch gekennzeichnet, dass** der Flipchip (9) nach der Entnahme vom Wafer (10) an eine Flip-Vorrichtung (2) übergeben wird, die den Flipchip (9) um 180° dreht und in der Kavität (11) der Benetzungsstation (3) absetzt.

3. Pick and Place System für die Montage eines Flipchips (9) auf einem Substrat (16), wobei der Flipchip (9) an einer Oberfläche angeordnete Bumps enthält, mit einer Benetzungsstation (3) mit mindestens einer Kavität (11) zum Benetzen der Bumps des Flipchips (9) mit Flussmittel, **dadurch gekennzeichnet, dass** ein Antrieb (15) vorhanden ist, um die mindestens eine Kavität (11) zwischen einem ersten Ort, wo der Flipchip (9) in der mindestens einen Kavität (11) abgesetzt wird, und einem zweiten Ort, wo der Flipchip (9) von einem Bestückungskopf (4) übernommen wird, hin und her zu bewegen.
